# EUROPEAN PATENT APPLICATION

(11) **EP 0 674 390 A1**
(43) Date of publication of application: **27.09.1995**
(21) Application number: 95200670.8
(22) Date of filing: 20.03.1995
(51) Int. Cl.: H03K 17/16, H02M 5/22

(54) **A device for regulating power transferred to an electrical load**

(30) Priority: 21.03.1994 IT MI940522
(71) Applicant: BTICINO S.P.A., I-20122 Milano (IT)
(72) Inventor: Bernasconi, Danilo, I-21045 Gazzada Schianno (IT); Massa, Riccardo, I-24047 Treviglio (IT); Re Garbagnati, Guiseppe, I-21047 Saronno (IT)
(74) Representative: De Nova, Roberto

(57) **Abstract**

A device for regulating the power transferred from an alternating-current voltage supply (Vac) to an electrical load (L) is described and uses, as a static switch, a first switching means of the type with controllable conduction and cutting-off, for example, a power MOSFET (T1), and a second switching means of the type with triggered controllable conduction, for example, a triac (T2). A control circuit (12) provides the first switching means (T1) with a control voltage pulse (V1) having a phase shift relative to the supply voltage (Vac) determined by a manually-set control quantity, and provides the second switching means (T2) with a triggering current pulse (I2) the timing of which is correlated with the end of the control pulse.

The device is usable in electrical equipment for regulating the brightness of lamps and the speeds of electric motors, it does not require anti-interference filters, and it is characterized by a very low total dissipated power.

## Description

The present invention relates to devices for transferring power from an alternating-current electrical power source to an electrical load and, more particularly, to a device for regulating power transferred to an electrical load with the use of static switches with controllable switching.

It is known that devices with controllable static switches are used widely in electrical equipment for regulating the brightness of lamps and the speeds of electric motors. In many cases, this equipment uses, as static switches, semiconductor electronic components known as "triacs" and "thyristors", which are connected in series between the supply and the load. These devices operate, by means of a control circuit connected to their control electrodes, as switching means, the conduction of which is triggered by the control circuit so as to connect the supply circuit to the electrical load for a predetermined period for each half-wave of the alternating-current supply voltage. With components of this type, conduction stops automatically when the alternating supply current crosses zero. By varying the closure time of the static switch, the power transferred to the load can be varied, theoretically, between 0 and 100%. These devices are very simple and quite cheap, but they have a disadvantage intrinsic in the operating characteristics of "triacs" and "thyristors", consisting of the generation of sudden current variations during switching from the cut-off to the conductive states. To prevent radiofrequency interference due to these abrupt current variations, it is necessary to provide an electrical filter comprising a coil connected in series with the load. This coil is relatively expensive and bulky and, during the operation of the device, generates an irritating hum due to electrodynamic phenomena; it also contributes appreciably to the total power dissipated, since it dissipates a power which is added to that of the electronic component.

To avoid giving rise to this problem, it has been proposed to use, as static switches, semiconductor components such as MOSFET power transistors or IGBT devices, or even bipolar power transistors which, unlike "triacs" and "thyristors" which can only be switched on or triggered, also allow conduction with control of the switching on and switching off transients. With a suitable control circuit, it is possible to make the transistor conductive gradually when the alternating-current supply voltage crosses zero, to keep it conductive for a predetermined and adjustable portion of the half-wave of the alternating-current voltage, and to cut it off gradually before the next zero crossing. Since sudden transients are thus not generated, high-frequency interference does not arise and it is not necessary to use filter coils in order to comply with the standards relating to radio interference. The same principle is put into practice by controlling the time at which the closure of the circuit is effected with respect to the voltage zero, and by keeping the transistor conductive until the current zero is reached.

There are also problems in these cases, however, since the total power dissipated is quite high because of the relatively high channel resistance in the case of MOSFET transistors, or of the saturation voltage in the case of IGBT components, and because of the dissipation in one or two diodes which are normally used to polarize the current of the load in two power devices or in one power device, respectively. In order to limit this problem, it is necessary to use components with certain characteristics, for example, MOSFET transistors with low channel resistance, but, in this case, the production costs of the device become quite high.

The main object of the present invention is to provide a device for regulating the power transferred to an electrical load with the use of a static switch unit which has the advantages of the known devices but not their disadvantages, that is, which is inexpensive, quiet, and compact, and which has relatively low overall power dissipation.

This object is achieved, according to the invention, by virtue of the fact that a first switching means of the type with controllable conduction and cutting-off, such as a MOSFET power transistor, and a second switching means of the type with triggered controllable conduction, such as a triac, are used together as the static switch unit, and in that it comprises a control circuit having pulse generators which can provide the first switching means with a control pulse of a predetermined duration shorter than a half-period of the alternating-current voltage and having a phase shift relative to this voltage, determined by a manually-adjustable control quantity, and which can provide the second switching means with a triggering pulse which starts at a predetermined moment within a period around the moment at which the control pulse ends.

The invention will be understood better from the following detailed description of two embodiments thereof, given by way of non-limiting example, with reference to the appended drawings, in which:
Figure 1 is a circuit diagram showing the concept of the device according to the invention,
Figure 2 is a block diagram showing some important functional elements of a circuit included in the device of Figure 1,
Figure 3 shows various waveforms which illustrate the operating characteristics of the device according to the invention, and
Figure 4 shows another embodiment of the invention.

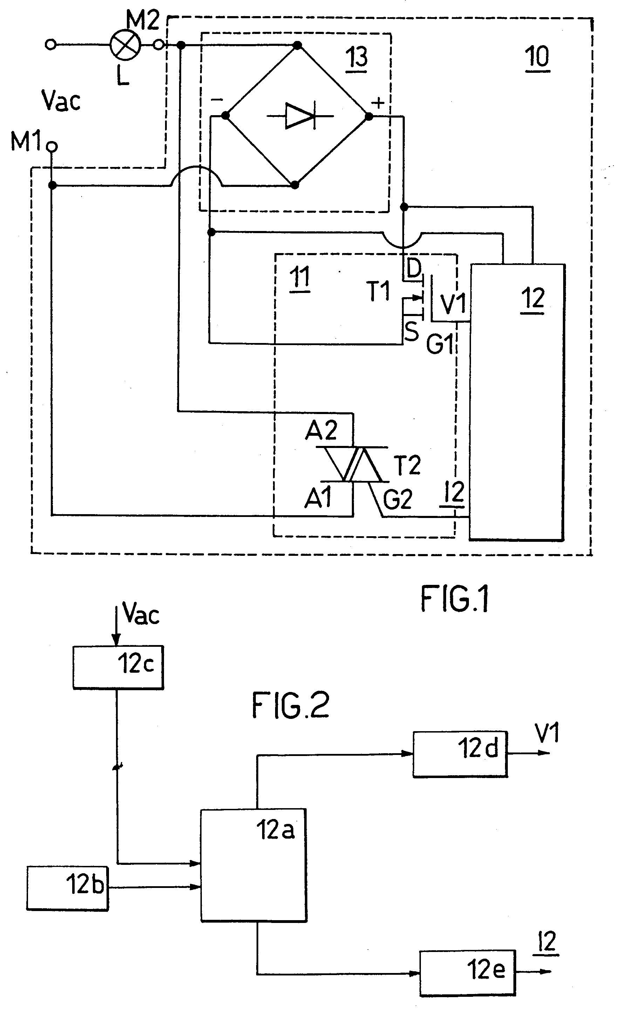

In Figure 1, an electrical load, indicated L, may be an incandescent lamp connected to an alternating-current voltage supply Vac, for example, the domestic supply mains, by means of a device, indicated 10, for regulating the power transferred to the load, that is, the brightness of the lamp, if the load is a lamp.

The device 10 is connected in series with the load L and the supply Vac by two terminals, indicated M1 and M2, and comprises a unit, indicated 11, with the function of a static two-way switch, a control circuit 12 connected to two control terminals of the unit 11, indicated G1 and G2, and a diode-bridge current rectifier, indicated 13, the input terminals of which are connected to the terminals M1 and M2 of the device 10. The positive and negative terminals of the rectifier 13 are also connected to the control device 12 to supply it with a supply voltage and a signal indicative of the phase of the alternating-current supply voltage of the load.

The unit 11 comprises a field-effect transistor T1, a power MOSFET, of which the power terminals, that is, the drain and source electrodes D and S, are connected to the positive and negative terminals of the rectifier 13, respectively, and the gate electrode is connected to the control terminal G1, and a triac T2 of which the two power terminals A1 and A2 are connected to the terminals M1 and M2 of the device 12, respectively, and the gate terminal is connected to the control terminal G2. As can be seen, the load L can be supplied by the supply Vac by means of two switching means, that is, either through the MOSFET T1 and two diodes of the rectifier 13 or through the triac T2, when, of course, these components are made conductive by the control circuit 12.

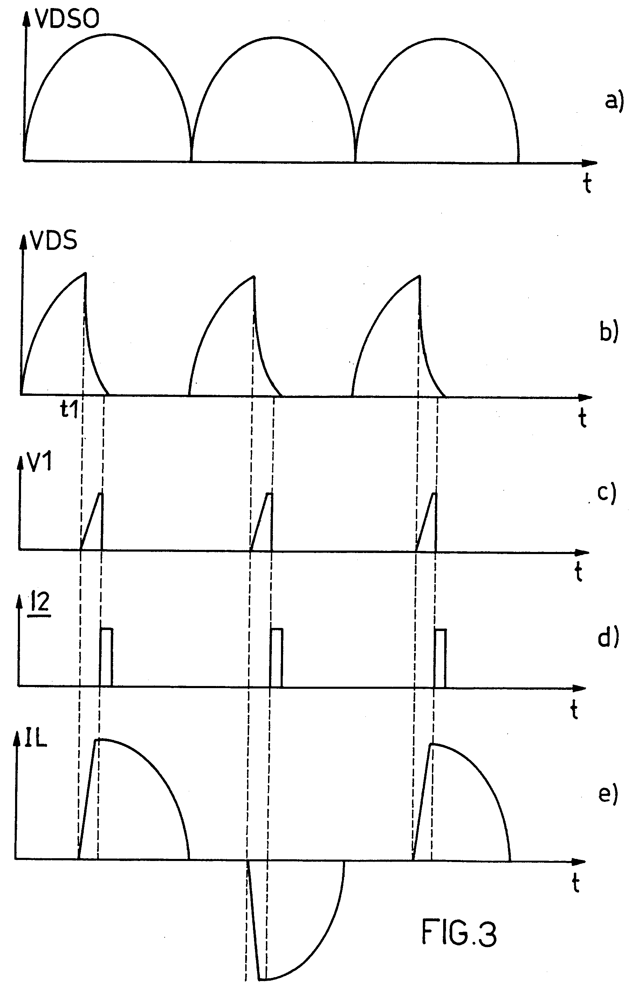

The control circuit 12, which is shown in greater detail in Figure 2, is constituted essentially by a control unit 12a, a manual control device 12b, a zero-crossing detector circuit 12c, a MOSFET control circuit 12d and a triac control circuit 12e. According to the invention, the control unit 12a controls the conduction times of the MOSFET T1 and of the triac T2 in the manner described below with reference to the waveforms of Figure 3, assuming that the load is purely resistive.

In the absence of control signals at the terminals G1 and G2, that is, with the MOSFET T1 and the triac T2 cut off, the voltage VDSO between the positive and negative poles of the rectifier has the known curve shown by the waveform of Figure 3a).

After a time interval t1 from the zero-crossing of the alternating-current supply voltage Vac, the control unit 12a, which advantageously is an integrated microcontroller circuit, generates a voltage pulse V1 at the control terminal G1, by means of the control circuit 12d, to make the MOSFET T1 conductive. The interval t1 is a control quantity which indicates the phase shift of the control voltage pulse V1 relative to the supply voltage Vac and is determined by the manual control device 12b. The interval t1 is variable substantially between 0 and a half-period of the alternating voltage, that is, in the case of a 50Hz voltage, between 0 and 10 milliseconds. The device 12b is, for example, a simple push-button switch acting on a timer which is included in the control unit and is reset periodically by the zero-crossing detected by the detector circuit 12c. The voltage pulse V1 shown in Figure 3c) has a gradual leading edge, in this example, with a ramp, and can thus make the MOSFET T1 conductive gradually, and preferably has a duration of between 20 and 200 microseconds. During the pulse V1, a current IL (Figure 3e)) passes through the load L and has a leading edge with a gradual trend correlated to that of the pulse V1. At the end of the pulse V1, the MOSFET T1 stops conducting and the control unit 12a generates a current pulse I2 at the terminal G2, by means of the control circuit 12e, to trigger the conduction of the triac T2. This pulse preferably has a duration of between 10 and 1000 microseconds. The current IL continues to flow in the load until the current IL is zeroed which, for a resistive load, coincides with the zero voltage, as shown in Figure 3e), that is, when the triac is switched off. During the next half-wave, there are generated another pulse V1, which makes the MOSFET T1 conductive throughout its duration, and another pulse I2, which triggers the conduction of the triac T2 again, this time in the opposite sense, so that the current IL in the load has a negative sign, as shown in Figure 3e). The cycle is then repeated in the same way. The voltage VDS between the drain and the source of the MOSFET T1 during the operation of the device is shown in Figure 3b).

As can be seen, the device according to the invention enables the power transferred to a load to be regulated without generating high-frequency interference, since the variations of the current in the load, particularly those which lead to the cut-off and conductive states, are gradual. It should also be noted that this result can be achieved with the use of a small MOSFET transistor with a relatively high channel impedance, since the power which it has to dissipate is very limited given its short conduction time, and it is therefore an inexpensive component. The total power dissipated is also low by virtue of the fact that the dissipation in the diodes of the rectifier which supplies the MOSFET transistor is also reduced to the short conduction time of the transistor. Finally, the total power dissipated is due mainly to the conduction of the triac.

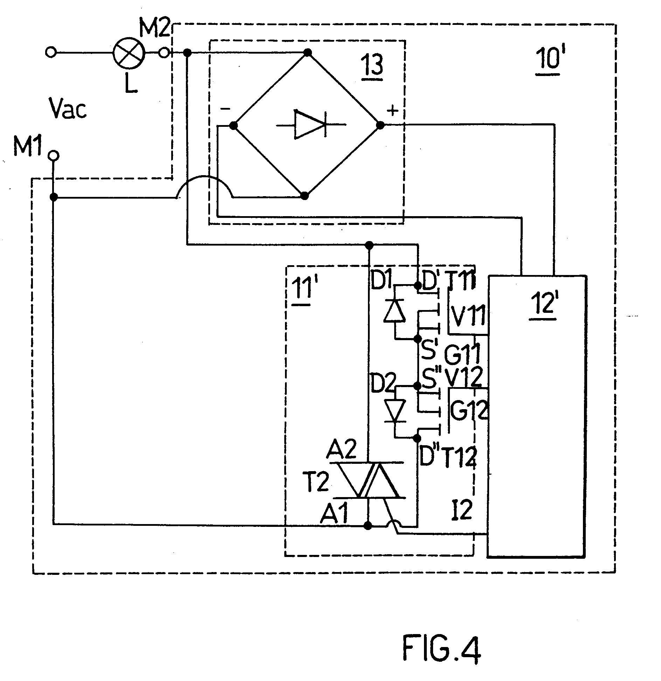

In the embodiment of the invention shown in Figure 4, instead of a single MOSFET transistor, the static switch unit, in this case indicated 11', comprises two MOSFET transistors, indicated T11 and T12, which are connected to one another with opposite polarities. More particularly, the two transistors have their source electrodes S' and S'' in common and their drain electrodes D' and D'' connected directly to the terminals M1 and M2 of the device, in this case indicated 10'. Two diodes D1 and D2 are connected in parallel with the two transistors T11 and T12, respectively, with their polarities reversed with respect to the direction of conduction of the corresponding transistors. The gate electrodes, indicated G11 and G12, are connected to the control circuit, in this case indicated 12', in order to receive therefrom respective control voltage pulses V11 and V12 which are out of phase with one another by 180⁰. In this embodiment, the rectifier 13 serves solely to supply the control circuit 12'. The operation of the regulator device 10' is exactly the same as that described above with reference to Figure 3; the only difference consists of the fact that the current is supplied to the load by means of one (T11) of the transistors during the positive half-wave of the alternating-current supply voltage Vac, when it is made conductive by a pulse V11, and by the other transistor (T12) during the negative half-wave, when it is made conductive by a pulse V12.

Although only two embodiments of the invention have been described and illustrated, clearly many variants and modifications are possible within the scope of the same inventive concept. For example, with reference to the circuit of Figure 1:
the triac could be connected between the positive and negative poles of the rectifier instead of directly in series with the load and the supply, although, naturally, in this case, it would be necessary to take into account the power dissipated in the diodes;
a bipolar transistor or an IGBT transistor, controlled by suitable current pulses, could be used instead of the MOSFET, and one or more thyristors could be used instead of the triac;
according to the power components used, or according to particular requirements, the pulse for triggering the triac could start at any predetermined moment within a period around the moment at which the control pulse of the transistor ends;
according to another variant, the control circuit 12 could be connected to the line upstream of the load in order to be supplied independently; in this case, the regulating device would have to have an additional terminal but a simpler supply circuit operating with lower power dissipation, for example, a capacitive supply, could be used.

## Claims

1. A device for regulating the power transferred by an alternating-current voltage supply to an electrical load, comprising:
a static power switch unit (11) which can be connected to the supply (Vac) in series with the load (L) by means of two terminals (M1, M2) of the device (10), and
a control circuit (12) connected to the switch unit (11) for controlling its conduction state in dependence on a control quantity determined by a manual control means (12b) connected to the control circuit,
characterized in that
the static switch unit (11) comprises a first switching means (T1) of the type with controllable conduction and cutting-off, having two power terminals (S, D) connected to the terminals (M1, M2) of the device (10) and at least one control terminal (G1), and a second switching means (T2) of the type with triggered controllable conduction, having two power terminals (A1, A2) connected to the terminals (M1, M2) of the device (10) and at least one control terminal (G2), and in that
the control circuit (12) comprises pulse-generator means connected to the control terminals (G1, G2) for providing the first switching means (T1) with at least one control pulse (V1) of a predetermined duration shorter than a half-period of the alternating-current voltage (Vac) and having a phase shift relative to that voltage, determined by the control quantity, and for providing the second switching means with at least one triggering pulse (I2) which starts at a predetermined moment within a period around the moment at which the control pulse (V1) ends.

2. A device according to Claim 1, in which the control pulse (V1) is generated at intervals equal to a half-period of the alternating-current voltage (Vac).

3. A device according to Claim 1 or Claim 2, in which the control pulse (V1) has a gradual leading edge.

4. A device according to Claim 1, Claim 2 or Claim 3, in which the leading edge of the triggering pulse (I2) is substantially contemporaneous with the trailing edge of the control pulse (V1).

5. A device according to any one of the preceding claims, in which the power terminals (S, D) of the first switching means (T1) are connected to the terminals (M1, M2) of the device (10) by means of a rectifier (13).

6. A device according to any one of the preceding claims, in which the power terminals (A1, A2) of the second switching means are connected to the terminals (M1, M2) of the device (10) by means of a rectifier.

7. A device according to Claim 5 or Claim 6, characterized in that the rectifier is a diode-bridge rectifier (13).

8. A device according to any one of the preceding claims, in which the first switching means is a field-effect transistor (T1) of which the source and drain electrodes (S) and (D) are the power terminals and the gate electrode (G1) is the control terminal.

9. A device according to any one of the preceding claims, in which the second switching means is a triac (T2) of which the gate electrode (D2) is the control terminal and the other two terminals (A1, A2) are the power terminals.

10. A device according to Claim 1, in which the first switching means is constituted by two field-effect transistors (T11, T12) connected to one another with opposite polarities and by two diodes (D1, D2), each connected in parallel and with reversed polarity to a respective transistor (T11, T12), the drain terminals (D', D'') of the two transistors being the two power terminals of the switch unit (11') and being connected directly to the terminals (M1, M2) of the device (10'), and the gate terminals (G11, G12) of the two transistors being two control terminals of the switch unit (11'), and in which the pulse-generator means of the control circuit (12') can provide the two transistors (T11, T12) with respective control pulses (V11, V12) which are out of phase with one another by 180⁰.
